# EUROPÄISCHE PATENTSCHRIFT

(11) **EP 1 657 963 B1**
(45) Veröffentlichungstag und Bekanntmachung des Hinweises auf die Patenterteilung: **14.03.2007**
(21) Anmeldenummer: 04026834.4
(22) Anmeldetag: 11.11.2004
(51) Int. Cl.: H05B 3/28, H05K 1/02, H01C 7/02

(54) **Elektrischer Platinenheizbaustein, Elektronikplatine und Verfahren zum Beheizen**
Electrical printed circuit board heating component, printed circuit board and heating process
Elément chauffant d'une carte de circuit imprimé, carte de circuit imprimé et procédé de chauffage

(43) Veröffentlichungstag der Anmeldung: 17.05.2006
(73) Patentinhaber: DBK David + Baader GmbH, 76870 Kandel (DE)
(72) Erfinder: von der Lühe, Friedrich, Discovery Bay City, Lantau Island (HK); Muirhead, William, 100 Shing Tai Road, Chaiwan (HK)
(74) Vertreter: Grünecker, Kinkeldey, Stockmair & Schwanhäusser Anwaltssozietät

(56) Entgegenhaltungen:
- EP-A- 0 371 644
- DE-A1- 4 010 620
- US-A- 4 352 008
- US-A- 4 414 052
- US-A- 5 270 521
- US-A1- 2004 104 215
- US-B1- 6 180 930

## Beschreibung

Die Erfindung betrifft einen elektrischen Platinenheizbaustein zum Beheizen von auf einer Elektronikplatine angeordneten Bauelementen sowie benachbarten Baueinheiten, mit wenigstens einem Befestigungselement, mit dem der Platinenheizbaustein neben den übrigen Bauelementen auf oder an der Elektronikplatine anbringbar ausgestaltet ist, mit wenigstens einem PCT-Heizelement zur Erzeugung von Wärmeenergie und mit wenigstens einem Heizkörper, der die im Betrieb des Platinenheizbausteins vom Heizelement erzeugte und die elektrischen Bauelemente beheizende Wärmeenergie über eine Wärmeabgabefläche abgibt und an dem ein oder mehrere als Konvektions-und Abstrahlelemente ausgebildete Heizvorsprünge angeordnet sind, durch welche die Wärmeabgabefläche vergrößert und die Wärmeenergie im Wesentlichen gerichtet abgebbar ist.

Elektrische Platinenheizbausteine der oben genannten Art sind im Stand der Technik bekannt und werden in verschiedenen Anwendungen eingesetzt:

Ein Einsatzgebiet solcher Platinenheizbausteine ist beispielsweise in elektrischen bzw. elektronischen Geräten, die im Freien bzw. unter kalten klimatischen Bedingungen betrieben werden, wie z.B. Sendeanlagen für Mobilfunk, Fahrscheinautomaten oder Außenkameras. Um negative Folgen der niedrigen Umgebungstemperatur für die auf einer Elektronikplatine oder Leiterplatte angeordneten elektrischen Bauelemente, wie z.B. verlängerte Ansprechzeiten oder Fehlfunktionen, zu vermeiden, werden der Platinenheizbaustein zum Erwärmen der Bauelemente auf eine vorbestimmte Temperatur auf den Elektronikplatinen angebracht.

Ein weiterer Einsatzgrund für die elektrischen Platinenheizbausteine ist z.B. eine hohe Luftfeuchtigkeit der Umgebungsluft, die zu einer unerwünschten und möglicherweise fehlerverursachenden Kondensation an den elektrischen Bauelementen führen kann. Durch den oben genannten Platinenheizbaustein, der die Bauelemente auf eine Temperatur oberhalb einer Kondensationstemperatur erwärmt, wird die Kondensation verhindert.

Beispiele für solche Platinenheizbausteine sind in der JP 2000188171A, der US 6,114,674 und der US 6,621,055 B2 beschrieben. Bei dem in der JP 2000188171A beschriebenen Platinenheizbaustein werden zwei an einer Elektronikplatine angeordnete Heizelemente durch ein Verstärkerelement temperaturabhängig beheizt. In der US 6,114,674 und der US 6,621,055 B2 sind jeweils Elektronikplatinen beschrieben, in denen eine Heizschicht zum Beheizen der auf der Elektronikplatine angeordneten Bauelementen integriert ist.

Weitere Heizelemente aus dem Stand der Technik, die allerdings nicht als Platinenheizbausteine ausgebildet sind, sind beispielsweise aus der US-A-5,270,521 bekannt, in der eine Heizvorrichtung mit einem PTC-Heizelement beschrieben ist. Weitere Heizbausteine mit PTC-Heizelementen sind in der DE-A-40 10 620, der US-A-4,414,052 und der US-B-6,180,930 beschrieben.

Ein weiteres Einsatzgebiet des oben genannten Platinenheizbausteins ergibt sich im Zusammenhang mit elektrischen Bauelementen, die im Betrieb eine möglichst konstante Temperatur benötigen, wie z.B. Oszillatoren.

Solche Platinenheizbausteine für Oszillatoren sind beispielsweise in der US 6,559,728 B1 und der JP 2000315916A beschrieben. Bei der US 6,559,728 B1 wird ein in einem Gehäuse angeordneter Oszillator von einem Heizelement gewärmt, das von einem Regelkreis gesteuert wird. In der JP 2000315916A ist ein piezoelektrischer Oszillator beschrieben, dessen Temperatur von einem Platinenheizbaustein mit einem Regelkreis gesteuert wird.

Nachteilig ist bei den genannten Platinenheizbausteinen aus dem Stand der Technik, dass die Herstellungskosten, bedingt durch einen großen Material- und Montageaufwand, sehr hoch sind.

Daher liegt der vorliegenden Erfindung die Aufgabe zugrunde, einen Platinenheizbaustein mit geringen Herstellungskosten zu liefern.

Diese Aufgabe wird erfindungsgemäß dadurch gelöst, dass der Platinenheizbaustein wenigstens einen elektrisch isolierenden Boden aufweist, mit dem der Platinenheizbaustein auf der Elektronikplatine anordenbar ausgebildet ist.

Diese Lösung ist konstruktiv besonders einfach und senkt die Herstellungskosten des Platinenheizbausteins dadurch, dass das PTC-Heizelement selbstregelnd und somit ohne eine teure Reglerschaltung ausgebildet ist und dass durch die als Konvektions- und Abstrahlelemente ausgebildeten Heizvorsprünge Wärmeenergie an eine Vielzahl von Bauelementen, die vom Platinenheizbaustein beabstandet sind, abgebbar ist.

Im Betrieb des Platinenheizbausteins wird Wärmeenergie von der durch die Heizvorsprünge vergrößerten Wärmeabgabefläche des Heizkörpers indirekt durch Konvektion über die Umgebungsluft oder direkt durch Wärmestrahlung gerichtet abgegeben. Die Wärmeenergie kann so auf sämtliche zu beheizenden Bauelemente auf der Elektronikplatine berührungslos übertragen werden. Der erfindungsgemäße Platinenheizbaustein ist relativ klein ausgestaltet, weil kein Kontakt zu den zu beheizenden Bauelementen nötig ist. Durch die geringe Baugröße des erfindungsgemäßen Platinenheizbausteins verringert sich der Materialaufwand und somit die Herstellungskosten.

Das erfindungsgemäße PTC-Heizelement (Positiv-Temperature-Coefficient) ist durch seine Materialeigenschaften selbstregelnd. Ein PTC-Heizelement, ein sogenanntes Kaltleiterheizelement, hat die Eigenschaft, im Betrieb, wenn es von elektrischer Energie durchströmt wird, in einem einstellbaren Bereich effektiv zu heizen. Ab einer bestimmten Temperatur erhöht sich der elektrische Widerstand des PTC-Heizelements derart, dass das Heizelement faktisch stoppt zu heizen. Durch diese Eigenschaft sind PTC-Heizelemente selbstregelnd und bedürfen somit keiner zusätzlichen kostenintensiven Temperatursteuerung.

Der solchermaßen verbesserte elektrische Platinenheizbaustein kann durch verschiedene, voneinander unabhängige, kombinierbare und jeweils für sich vorteilhafte Ausgestaltungen weiter entwickelt sein. Auf diese Ausgestaltungen und die mit den Ausgestaltungen jeweils verbundenen Vorteile wird im Folgenden kurz eingegangen.

So kann der Heizkörper als ein Strangpressprofil ausgebildet sein. Dies hat den Vorteil, dass das Strangpressprofil in großen Stückzahlen besonders kostengünstig hergestellt werden kann. Weiterhin zeichnen sich Strangpressprofile durch besonders gute Formgenauigkeit und Oberflächengüte aus, wodurch auf eine Bearbeitung des Heizkörpers nach dem Strangpressen verzichtet werden kann. Weiterhin kann der Heizkörper aus einem besonders wärmeleitfähigen Material, z.B. Aluminium, hergestellt sein.

Der Heizkörper kann in einer vorteilhaften Weiterbildung eine Aufnahme aufweisen, in der das Heizelement angeordnet ist. Hierdurch kann das Heizelement bei der Montage des Platinenheizbausteins besonders einfach und schnell zum Heizkörper positioniert und ausgerichtet werden. So kann eine schnelle Montage des erfindungsgemäßen Platinenheizbausteins erfolgen. Ferner kann das Heizelement zum Befestigen in der beispielsweise kanalförmig ausgestalteten Aufnahme verpresst sein. Durch das Verpressen wird weiterhin ein guter Wärmeübergang zwischen Heizelement und Heizkörper gewährleistet. Alternativ kann das Heizelement beispielsweise auch durch einen geeigneten Klebstoff, der z.B. besonders gut wärmeleitfähig ist, in der Aufnahme befestigt werden. Weiterhin kann das Heizelement zum Befestigen mit einer wärmeleitfähigen Vergussmasse in der Aufnahme vergossen sein. Durch diese Ausgestaltung können Ungenauigkeiten in den Oberflächen des Heizelements und/oder der Aufnahme ausgeglichen werden und es sind größere, kostengünstigere Form- und Lagetoleranzen von der Aufnahme bzw. dem Heizelement möglich. Zur einfachen Fertigung durch Strangpressen kann die Aufnahme als ein in der Strangpressrichtung verlaufender Durchgangskanal im Heizkörper ausgebildet sein.

Um das Heizelement nach außen elektrisch zu isolieren, können in den Enden der als ein Durchgangskanal ausgebildeten Aufnahme elektrisch isolierende Verschlusselemente angeordnet sein. Wenigstens eines der Verschlusselemente kann den Heizkörpern ferner in einer Richtung elektrisch isolieren und/oder eine Auflagefläche des Platinenheizbausteins ausbilden.

Die Heizvorsprünge können so ausgebildet sein, dass sie vom Heizkörper im Wesentlichen in einer Heizrichtung, insbesondere rechtwinklig zur Längsachse, nach außen wegstehen und parallel zueinander verlaufen, um die Wärmeenergie besonders effektiv und gerichtet abgeben zu können. Zwischen den Heizvorsprüngen können Zirkulationskanäle ausgebildet sein, die von einem Umgebungsgas, z.B. Luft, durchströmbar sind, um die Konvektion im Betrieb des Platinenheizbausteins zu erhöhen.

Um die Herstellungskosten des erfindungsgemäßen Platinenheizbausteins und dessen Montageaufwand zu reduzieren, kann der Heizkörper mit einem Elektrodenkörper des Heizelementes einteilig ausgestaltet sein. Bei dieser Ausführungsform wird der wenigstens eine Heizkörper direkt am PTC-Element angebracht. Die Anlagefläche des Heizkörperes ist mit der Anlagefläche des PTC-Elementes im Wesentlichen gleich ausgebildet, um einen guten elektrischen und thermischen Fluss zwischen Heizkörper und Heizelement zu ermöglichen. Der Heizkörper kann mit dem Heizelement z.B. durch einen Klebstoff, ein Spannelement oder durch Löten verbunden sein.
Zum Verringern des Installationsaufwands des erfindungsgemäßen Platinenheizbausteins auf der Elektronikplatine, kann das Befestigungselement als elektrisches Kontaktelement ausgebildet sind, das zur Energieversorgung des Platinenheizbausteins mit einer Energiequelle elektrisch verbindbar ausgestaltet ist. So wird der Platinenheizbaustein bei der Montage auf der Elektronikplatine in einem Arbeitsschritt befestigt und elektrisch leitend mit der Elektronikplatine verbunden, was zu einer besonders schnellen Installation des Platinenheizbausteins führt. Das Befestigungselement kann beispielsweise stoffschlüssig, z.B. durch Löten, mit der Elektronikplatine verbunden sein. Ferner kann das Befestigungselement als Steckverbinder ausgebildet sein, der in die Elektronikplatine einsteckbar ist, z.B. in einen entsprechenden Gegenstecker. Dies hat den Vorteil, dass das Befestigungselement besonders schnell und wiederholt lösbar mit der Elektronikplatine verbunden werden kann. Der Steckverbinder kann als ein standardisierter Steckverbinder ausgebildet sein, der besonders kostengünstig ist.

Um die Materialkosten und die Montagezeit des erfindungsgemäßen Platinenheizbausteins zu reduzieren, kann das Befestigungselement mit dem Elektrodenkörper des Heizelementes einteilig ausgebildet sein.

In einer weiteren vorteilhaften Ausgestaltung kann am Platinenheizbaustein eine Kontaktheizfläche ausgebildet sein, an der ein durch Kontakt zu beheizendes Heizelement wärmeleitend angeordnet ist. Dies hat den Vorteil, dass zusätzlich zum Beheizen der beabstandeten Bauelemente durch die Heizvorsprünge des Heizkörpers auch das durch Kontakt zu beheizende Bauelement durch den erfindungsgemäßen Platinenheizbaustein beheizt wird. Das an der Kontaktheizfläche angeordnete Bauelement kann im Betrieb des Platinenheizbausteins besonders schnell durch Wärmeleitung beheizt werden. Die Kontaktheizfläche kann ferner in einem Heizflächenbereich und die Heizvorsprünge in einem Heizvorsprungbereich des Heizkörpers ausgebildet sein. Das Bauteil kann ferner mit einem geeigneten Befestigungsmittel, z.B. einer Schraube, an der Kontaktheizfläche befestigt sein.

In einer vorteilhaften Ausgestaltung kann die Grenztemperatur, bei der sich der elektrische Widerstand des erfindungsgemäßen PTC-Elementes ändert, abhängig vom Material des PTC-Elements ausgestaltet sein. Dies hat den Vorteil, dass die Grenztemperatur durch das Variieren der Materialien bzw. Materialkombination des PTC-Elementes je nach Anwendungsfall unterschiedlich voreingestellt werden kann. So kann beispielsweise die Grenztemperatur eines aus BaTiO₃ bestehenden PTC-Elements durch einen zusätzlichen Strontium- oder Bleianteil verändert werden. Durch einen Strontiumanteil verringert sich die Grenztemperatur und durch einen Bleianteil erhöht sie sich. Durch diese Ausgestaltung ist es möglich, die Temperatur des Heizelementes, bei der das Heizelement faktisch stoppt Wärmeenergie zu erzeugen, je nach Anwendungsfall voreinzustellen. Hierdurch ist der erfindungsgemäße Platinenheizbaustein für viele verschiedene Anwendungen mit unterschiedlichen Solltemperaturen einsetzbar.

Die Erfindung betrifft neben dem oben erläuterten elektrischen Platinenheizbaustein und dessen Ausgestaltungen auch eine Elektronikplatine mit wenigstens einem elektrischen Platinenheizbaustein und anderen elektrischen Bauelementen, wobei der Platinenheizbaustein zum Beheizen der übrigen Bauelemente ausgebildet und mit wenigstens einem Befestigungselement neben den übrigen Bauelementen auf oder an der Elektronikplatine angebracht ist. Um die Herstellungskosten der erfindungsgemäßen Elektronikplatine zu reduzieren, ist der nach einem der oben genannten Ansprüche ausgestaltete Platinenheizbaustein so auf der Elektronikplatine angeordnet, dass sich im Betrieb die vom Platinenheizbaustein erzeugte Wärmenergie direkt durch Wärmestrahlung oder indirekt durch Konvektion über ein Umgebungsgas, wie z.B. Luft, zu den vom Platinenheizbaustein beabstandeten Bauelementen überträgt.

In einer vorteilhaften Ausgestaltung der elektrischen Elektronikplatine kann der Platinenheizbaustein als eine vormontierbare separate Baueinheit ausgebildet sein. So kann der Platinenheizbaustein unabhängig von der Elektronikplatine montiert und hergestellt werden, wodurch sich die Montagezeit der Elektronikplatine verkürzt.

Die Erfindung betrifft neben dem oben beschriebenen Platinenheizbaustein und der Elektronikplatine mit ihren weiteren Ausführungsformen auch ein Verfahren zum Beheizen von auf einer Elektronikplatine angeordneten elektrischen Bauelementen mit einer auf der Elektronikplatine angeordneten und ein Heizelement und einen Heizkörper umfassenden Platinenheizbaustein, wobei bei dem Verfahren Wärmeenergie durch das Heizelement erzeugt, an den Heizkörper übertragen und von Heizvorsprüngen des Heizkörpers indirekt durch Konvektion über ein Umgebungsgas, wie z.B. Luft, und/oder direkt durch Wärmestrahlung an die zu beheizenden Bauelemente übertragen wird.
Im Folgenden wird die Erfindung beispielhaft mit Bezug auf die beigefügten Zeichnungen erläutert. Die unterschiedlichen Merkmale können dabei unabhängig voneinander kombiniert werden, wie dies oben bei den einzelnen vorteilhaften Ausgestaltungen bereits dargelegt wurde.

Es zeigen:
- Fig. 1: eine erste Ausführungsform des erfindungsgemäßen Platinenheizbausteins schematisch in einer perspektivischen Ansicht;
- Fig. 2: die Ausführungsform des Platinenheizbausteins aus Fig. 1 in einer schematischen Explosionsdarstellung;
- Fig. 3: eine erste Ausführungsform einer erfindungsgemäßen Elektronikplatine mit dem Platinenheizbaustein aus Fig. 1 schematisch in einer perspektivischen Ansicht;
- Fig. 4: ein beispielhaftes Temperatur-Widerstands-Diagramm eines PTC-Elementes;
- Fig. 5: ein Diagramm mit verschiedenen beispielhaften Widerstand-Temperatur-Charakteristika von PTC-Elementen aus BaTiO₃ mit unterschiedlichen Sr- oder Pb-Anteilen;
- Fig. 6: eine schematische Darstellung einer zweiten Ausführungsform eines erfindungsgemäßen elektrischen Platinenheizbausteins;
- Fig. 7: die zweite Ausführungsform des elektrischen Platinenheizbausteins aus Fig. 6 in einer schematischen Explosionsdarstellung;
- Fig. 8: eine zweite Ausführungsform der erfindungsgemäßen Elektronikplatine mit dem Platinenheizbaustein aus Fig. 6 schematisch in einer perspektivischen Ansicht;
- Fig. 9: eine dritte Ausführungsform des erfindungsgemäßen Platinenheizbausteins schematisch in einer perspektivischen Ansicht;
- Fig. 10: die dritte Ausführungsform des erfindungsgemäßen Platinenheizbausteins aus Fig. 9 in einer schematischen Explosionsdarstellung;
- Fig. 11: eine zweite Ausführungsform der erfindungsgemäßen Elektronikplatine mit dem Platinenheizbaustein aus Fig. 9 schematisch in einer perspektivischen Ansicht.

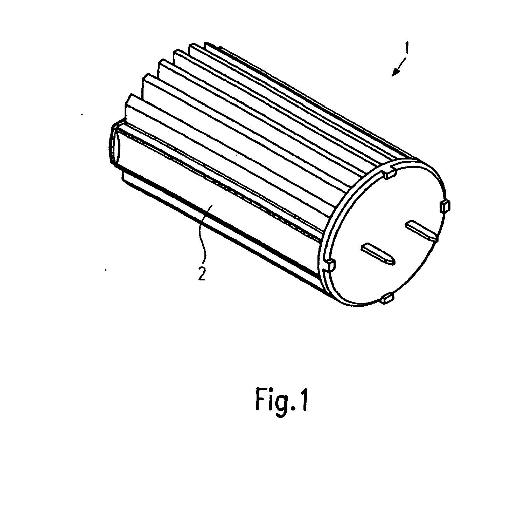

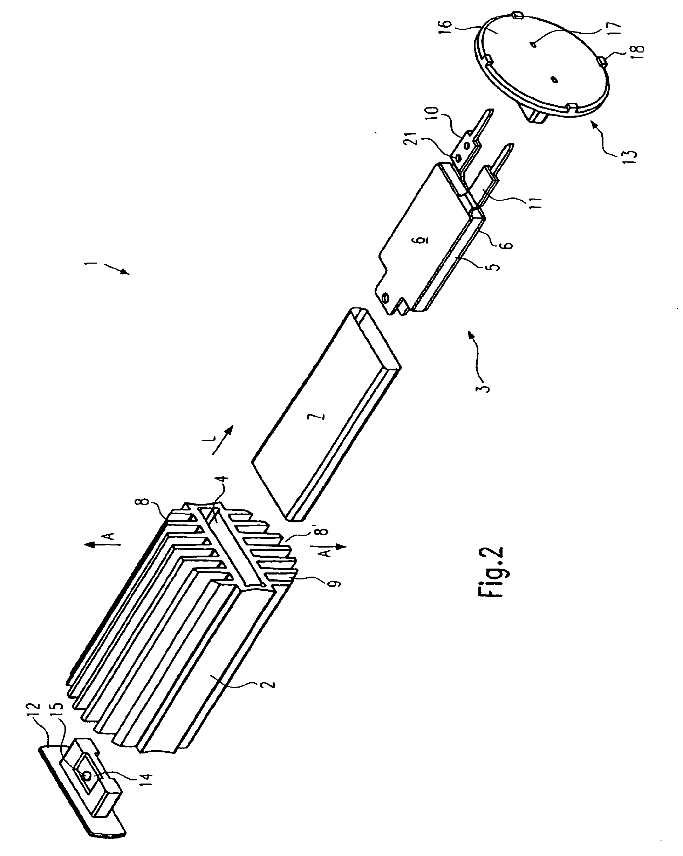

Zunächst wird der allgemeine Aufbau eines erfindungsgemäßen elektrischen Platinenheizbausteins mit Bezug auf die Fig. 1 und 2 beschrieben.

Die Fig. 1 und 2 zeigen eine erste beispielhafte Ausführungsform des erfindungsgemäßen elektrischen Platinenheizbausteins 1 mit einem Heizkörper 2 und einem Heizelement 3. Der Heizkörper 2 bildet eine als Kanal ausgestaltete Aufnahme 4 aus, in der das Heizelement 3 angeordnet ist.

Das Heizelement 3 weist in der in Fig. 1 und 2 dargestellten Ausführungsform wenigstens ein PTC-Element oder einen PTC-Baustein 5, zwei Elektrodenkörper 6 und ein Isolierelement 7 auf. Das Heizelement 3 ist als ein Stapel ausgebildet, bei dem das PTC-Element 5 zwischen den beiden plattenförmigen Elektrodenkörpern 6 angeordnet ist. Das als schlauchförmige Folie ausgebildete Isolierelement 7 umschließt das PTC-Element 5 und die Elektrodenkörper 6. Bei der in Fig. 2 beispielhaft dargestellten Ausführungsform umfasst das Heizelement 3 ein PTC-Element 5. Alternativ kann das Heizelement 3 auch mehrere PTC-Elemente 5 aufweisen.

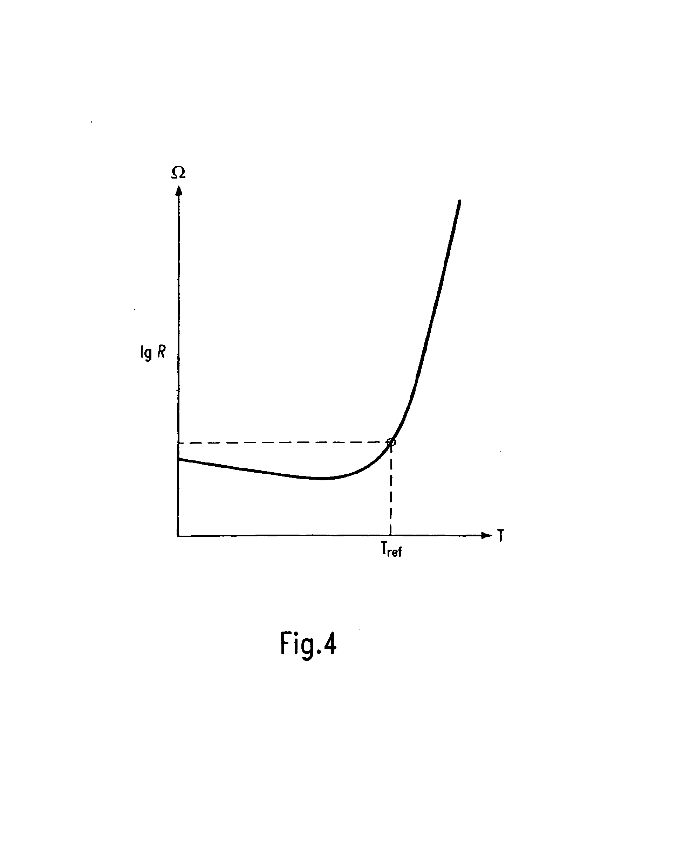

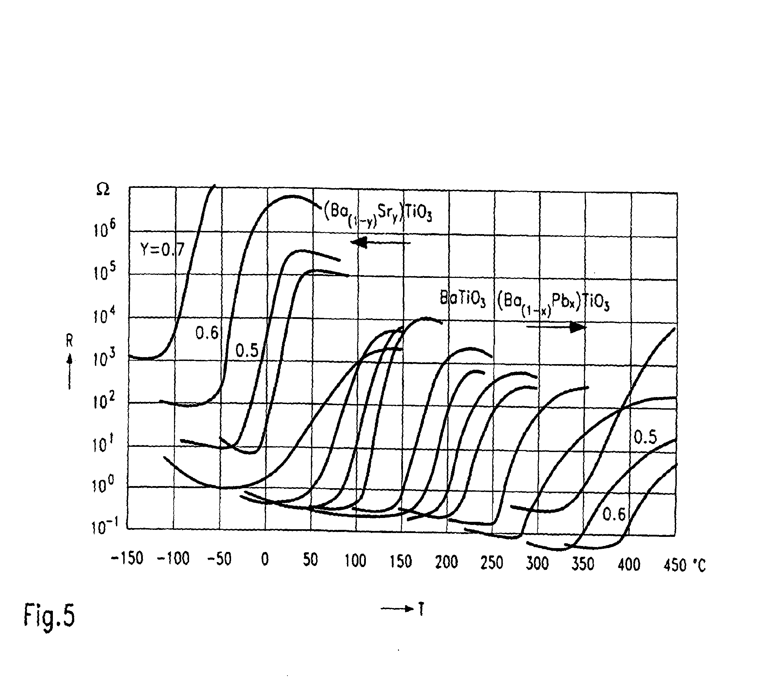

Das wenigstens eine PTC-Element 5 (Positive-Temperature-Coefficient), ein sogenannter Kaltleiter, erhöht seinen elektrischen Widerstand etwa ab einer Grenztemperatur T_{ref} sprungartig. Diese Widerstand-Temperatur-Charakteristik ist beispielhaft in Fig. 4 dargestellt. Unterhalb der Grenztemperatur T_{ref} hat das PTC-Element 5 einen relativ geringen elektrischen Widerstand. Ab der Grenztemperatur T_{ref} steigt der elektrische Widerstand R, wie in Fig. 4 dargestellt, an und das PTC-Element 5 erzeugt in seinem Arbeitspunkt Wärmeenergie. Der Arbeitspunkt (nicht dargestellt) liegt oberhalb der Grenztemperatur T_{ref} und stellt sich ein, wenn ein Gleichgewicht zwischen erzeugter und abgegebener Wärmeenergie herrscht. Die Grenztemperatur T_{ref} ist abhängig vom Material des PTC-Elements. Für unterschiedliche Anwendungen können unterschiedliche PTC-Elemente 5 mit unterschiedlichen Grenztemperaturen T_{ref} hergestellt werden. Das PTC-Element ist dabei beispielsweise als ein Keramikelement aus BaTiO₃ ausgebildet. Beim Herstellen des PTC-Elements 5 aus BaTiO₃ kann die Grenztemperatur durch einen zusätzlichen Strontiumanteil verringert und durch einen zusätzlichen Bleianteil erhöht werden. Fig. 5 zeigt verschiedene Widerstandstemperaturkurven von PTC-Elementen 5, die aus Ba-TiO₃ mit unterschiedlichen Sr- bzw. Pb-Anteilen hergestellt sind.

Von den Elektrodenkörpem 6 wird im Betrieb des Platinenheizbausteins 1 elektrische Energie in das PTC-Element 5 eingeleitet, wodurch das Heizelement 3 Wärmeenergie erzeugt. Die Elektrodenkörper 6 sind als Kontaktplatten ausgestaltet und aus einem Material hergestellt, das sowohl eine hohe thermische als auch elektrische Leitfähigkeit aufweist, wie z.B. Kupfer oder Aluminium.

Das Isolierelement 7 isoliert das Sandwich aus dem wenigstens einen PTC-Element 5 und den Elektrodenkörpern 6 in Richtung des Heizkörperes 2. Um eine gute Wärmeleitung vom PTC-Element 5 bzw. den Elektrodenkörpem 6 zum Heizkörper 2 zu gewährleisten, ist das Isolierelement 7 aus einem besonders wärmeleitfähigen Material hergestellt. Bei der in den Fig. 1 und 2 beispielhaft dargestellten Ausführungsform ist das Isolierelement 7 aus einer Polyimidfolie, insbesondere aus einer Kaptonfolie, hergestellt. Die Kaptonfolie hat den Vorteil, dass sie besonders wärmeleitfähig, elektrisch isolierend und außerdem druckfest ist, um gegebenenfalls eine Vorspannung auf die Elektrodenkörper 6 zu übertragen. Das in Fig. 2 dargestellte Isolierelement 7 ist als Schlauch ausgebildet, in den das PTC-Element 5 und die Elektrodenkörper 6 bei der Montage des Platinenheizbausteins schnell einschiebbar sind. Das schlauchförmige Isolierelement 7 kann nach dem Einschieben des Stapels aus dem PTC-Element 5 und der Elektrodenkörper 6 an den Enden verschlossen, z.B. verschweißt, werden.

Um einen guten Wärmeübergang und sicheren Halt zwischen dem wenigstens einen Heizelement 3 und dem Heizkörper 2 zu erreichen, ist das Heizelement 3 in der in Fig. 1 und 2 dargestellten Ausführungsform in der Aufnahme 4 des Heizkörpers 2 verpresst. Beim Verpressen wird die Aufnahme 4, in die das Heizelement 3 eingeschoben wurde, querschnittsverformt. Dies kann beispielsweise durch eine von außen am Heizkörper 2 angreifende Zange oder eine andere Presseinrichtung geschehen. Alternativ zum Verpressen kann das Heizelement 3 auch in der Aufnahme 4 verklebt oder vergossen sein. Der Klebstoff bzw. die Vergussmasse sind hierbei besonders wärmeleitfähig ausgebildet. Das Vergießen des Heizelements 3 hat den Vorteil, dass die Vergussmasse Ungenauigkeiten der Heizelement- und/oder der Aufnahmeoberflächen, wie z.B. Riefen, ausgleichen kann, so dass keine wärmeisolierenden Lufteinschlüsse entstehen.

Die Aufnahme 4 ist bei der in Fig. 1 und 2 dargestellten Ausführungsform als durchgängiger Kanal im Heizkörper 2 ausgebildet.

Der Heizkörper 2 weist neben der bereits beschriebenen Aufnahme 4 mehrere in einer Längsrichtung L verlaufende, im Wesentlichen parallel zueinander angeordnete Heizvorsprünge 8 auf. Die Heizvorsprünge 8 sind als hochkant stehende Platten ausgebildet, die im Wesentlichen rechtwinklig vom Heizkörper 2 weg verlaufen. Die Länge der Heizvorsprünge 8 in Längsrichtung L ist im Wesentlichen gleich lang mit dem übrigen Heizkörper 2. Die Länge der Heizvorsprünge 8 quer zur Längsrichtung L verringert sich insbesondere bei der in den Fig. 1 und 2 dargestellten Ausführungsform zu den Seiten des Heizkörpers. Im Querschnitt des Heizkörpers 2 liegen die vom Heizkörper 2 wegstehenden Enden der Heizvorsprünge 8 im Wesentlichen auf einer Kreisbahn. Zwischen den Heizvorsprüngen 8 sind Zirkulationskanäle 8' ausgebildet.

Die im Betrieb des Platinenheizbausteins 1 vom Heizelement 3 erzeugte Wärmeenergie wird an den Heizkörper 2 geleitet. Die Außenfläche des Heizkörpers 2 ist die Wärmeabgabefläche 9, von der die Wärmeenergie nach außen abgegeben wird. Um die Außenfläche 9 und die mögliche Wärmeabgabe des Heizkörpers 2 möglichst groß auszugestalten, sind am Heizkörper 2 die Heizvorsprünge 8 angeordnet. Die Heizvorsprünge 8 sind als Konvektions- und Abstrahlelemente ausgebildet. Die im Betrieb des Platinenheizbausteins 1 erzeugte Wärmeenergie wird von den Heizvorsprüngen 8 in einer Heizrichtung A abgestrahlt, die im Wesentlichen in der Richtung der vom Heizelement 3 wegstehenden Heizvorsprünge 8 verläuft. Weiterhin wird die erzeugte Wärmeenergie vom Heizkörper 2 durch Konvektion über die Umgebungsluft im Wesentlichen in der Heizrichtung A abgegeben. Die Umgebungsluft umströmt die Wärmeabgabefläche 9 des Heizkörpers 2 in den Zirkulationskanälen 8'. In den im Querschnitt im Wesentlichen U-förmigen Zirkulationskanälen 8' wird die Umgebungsluft besonders schnell erwärmt. Die erwärmte Umgebungsluft wird von den Heizvorsprüngen 8 in der Heizrichtung A vom Heizkörper 2 weg geleitet.

Der in den Fig. 1 und 2 dargestellte Heizkörper 2 ist als ein Strangpressprofil ausgebildet, wodurch er in großen Stückzahlen kostengünstig herstellbar ist. Das Strangpressprofil hat den weiteren Vorteil, dass es besonders formgenau und mit einer hohen Oberflächengüte herstellbar und keine Nachbearbeitung des Heizkörpers 2 nach dem Strangpressen erforderlich ist. Damit die Aufnahme 4 und die Heizvorsprünge 8 in einem Arbeitsschritt beim Strangpressen ausgebildet werden können, verlaufen sie in der Längsrichtung L des Heizkörpers 2, die gleichzeitig die Strangpressrichtung ist.

An einem Ende in Längsrichtung L des elektrischen Platinenheizbausteins 1 sind zwei Befestigungselemente 10 im Wesentlichen parallel zueinander angeordnet. Die Befestigungselemente 10 sind in Fig. 2 insbesondere jeweils mit einem der beiden Elektrodenkörper 6 verbunden. An dem vom Heizelement 3 wegstehenden Ende sind die Befestigungselemente 10 als spitz zulaufende flache Steckverbinder ausgebildet.

Durch die Befestigungselemente 10 kann der Platinenheizbaustein 1 auf oder an einer Elektronikplatine angebracht werden, wie es im Folgenden noch näher beschrieben wird. Die Befestigungselemente 10 sind aus einem elektrisch leitfähigen Material als Kontaktelemente der Elektrodenkörper 6 ausgebildet, durch die der Platinenheizbaustein 1 mit einer elektrischen Energiequelle verbindbar ist. Bei der in Fig. 2 dargestellten Ausführungsform sind die Befestigungselemente 10 insbesondere mit Kontaktplatten 11 der Elektrodenkörper 6 durch Nieten 21 verbunden. Selbstverständlich können die Befestigungselemente 10 auch durch andere Befestigungsmittel, wie z.B. Schrauben, oder z.B. durch Kleben mit den Elektrodenkörpern 6 verbunden sein. Alternativ können die Befestigungselemente 10 auch einteilig mit den Elektrodenkörpem 6 ausgebildet sein.

Im montierten Zustand des elektrischen Platinenheizbausteins 1 der Fig. 1 und 2 sind ein oberes und ein unteres Verschlusselement 12, 13 jeweils in eine Endöffnung der als Durchgangskanal ausgestalteten Aufnahme 4 eingesteckt. Das im Querschnitt T-förmige obere Verschlusselement 12 weist zwei Taschen 14 mit einem Rastmittel 15 auf. Das untere Verschlusselement 13, das im Querschnitt ebenfalls T-förmig ausgebildet ist, weist einen kreisförmigen Boden 16 auf. In dem kreisförmigen Boden 16 sind zwei Öff-nungen 17 und mehrere Fixierelemente 18 ausgebildet.

Durch die Verschlusselemente 12, 13 wird die Aufnahme 4 verschlossen und das Heizelement nach außen elektrisch isoliert. Die Verschlusselemente 12, 13 sind aus einem elektrisch isolierenden Material, z.B. einem Kunststoff, hergestellt.

Die Taschen 14 des oberen Verschlusselements 12 sind so ausgeformt, dass jeweils ein Elektrodenkörper 6 des Heizelements 3 in den Taschen 14 angeordnet werden kann. Das Rastmittel 15 ist in eine Gegenraste am Elektrodenkörper 6, z.B. ein Loch, einrastbar, wodurch das obere Verschlusselement 12 befestigt wird.

Der Durchmesser des kreisförmigen Bodens 16 des unteren Verschlusselements 13 ist im Wesentlichen gleich mit dem Außendurchmesser des Heizkörpers 2 der in Fig. 1 und 2 dargestellten Ausführungsform. Im montierten Zustand führen die Befestigungselemente 10 durch die Öffnungen 17 hindurch. Durch den kreisförmigen Boden 16 wird ein Ende des Heizkörpers 2 elektrisch und thermisch in der Längsrichtung L nach außen isoliert. Der Boden 16 ist die Auflagefläche, mit welcher der Platinenheizbaustein 1 auf einer Elektronikplatine anordenbar ist. Die Fixierelemente 18 verdrehsichern die Platinenheizbaustein 1, wenn der Platinenheizbaustein 1 auf der Elektronikplatine angeordnet ist.

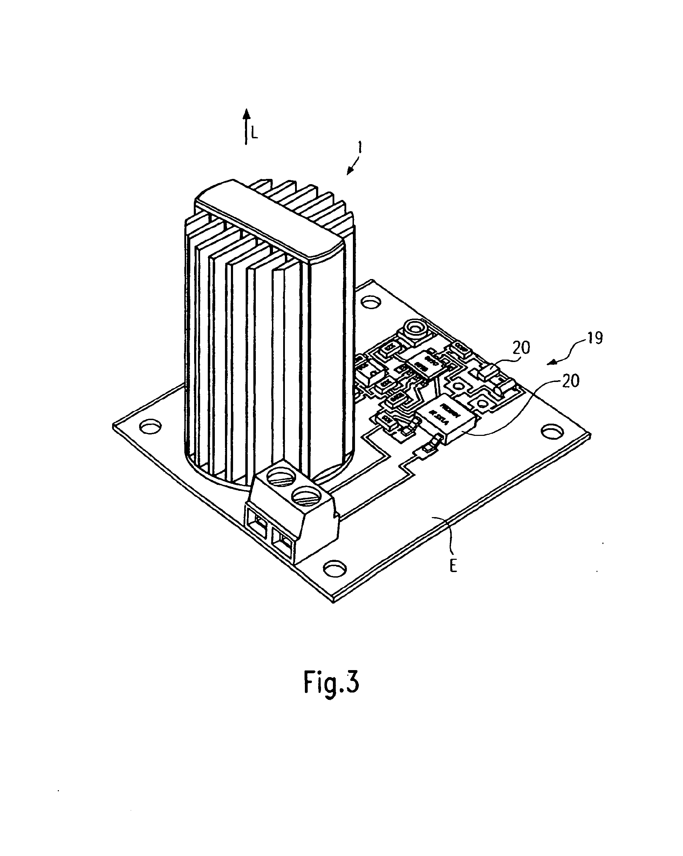

Fig. 3 zeigt eine erste Ausführungsform einer erfindungsgemäßen Elektronikplatine 19, auf der elektrische Bauelemente 20, wie z.B. Kondensatoren, Widerstände, Transistoren oder IC's (Integrated Circuit), und der erfindungsgemäße Platinenheizbaustein 1 aus den Fig. 1 und 2 angeordnet sind. Die elektrischen Bauelemente 20 sind vom Platinenheizbaustein 1 beabstandet auf der Elektronikplatine 19 angeordnet. Die Längsrichtung L des Platinenheizbausteins 1 verläuft im Wesentlichen senkrecht zur Platinenebene E der Elektronikplatine 19. Die Heizvorsprünge 8 stehen im Wesentlichen quer zur Längsrichtung L vom Heizkörper 2 ab. Der parallel zur Platinenebene E verlaufende Boden 16 des unteren Verschlusselements 13 liegt auf der Elektronikplatine 19 auf.

Der Platinenheizbaustein 1 ist durch die in Fig. 1 und 2 dargestellten Befestigungselemente 10 mit der Elektronikplatine 19 elektrisch leitend verbunden. Im Betrieb der erfindungsgemäßen Elektronikplatine 19 beheizt der erfindungsgemäße Platinenheizbaustein 1 die auf der Elektronikplatine 19 angeordneten elektrischen Bauelemente 20. Der Platinenheizbaustein 1 ist so auf der Elektronikplatine 19 angeordnet, dass die vom Heizelement 3 erzeugte Wärmeenergie durch Wärmestrahlung und durch Konvektion über die Umgebungsluft vom Heizkörper 2 in der Heizrichtung A abgegeben wird und die Bauelemente 20 erwärmt. Durch den Platinenheizbaustein 1 können so sämtliche auf der Elektronikplatine 19 angeordnete elektrische Bauelemente berührungslos beheizt werden. Weiterhin können auch andere, nicht auf der Elektronikplatine 19 angeordnete Baueinheiten vom erfindungsgemäßen Platinenheizbaustein 1 durch Konvektion oder Wärmestrahlung beheizt werden.

Beim Beheizen der elektrischen Bauelemente 20 wird elektrische Energie von der Elektronikplatine 19 an die Befestigungselemente 10 geleitet. Die elektrische Energie wird über die Befestigungselemente 10 in das Heizelement 3 eingeleitet, das die elektrische Energie in Wärmeenergie umwandelt. Die erzeugte Wärmeenergie wird vom Heizelement an den Heizkörper 2 geleitet. Der Heizkörper 2 überträgt die Wärmeenergie von seinen Heizvorsprüngen 8 indirekt durch Konvektion über die Umgebungsluft, welche die Wärmeenergie in Richtung der elektrischen Bauelemente 20 transportiert, oder direkt durch Wärmestrahlung an die Bauelemente 20. Durch die Verwendung des erfindungsgemäßen Platinenheizbausteins 1 kann auf eine separate Temperatursteuerung verzichtet werden, da das PTC-Heizelement 3 selbstregelnd ist und so ein Überhitzen der Bauelemente 20 verhindert wird.

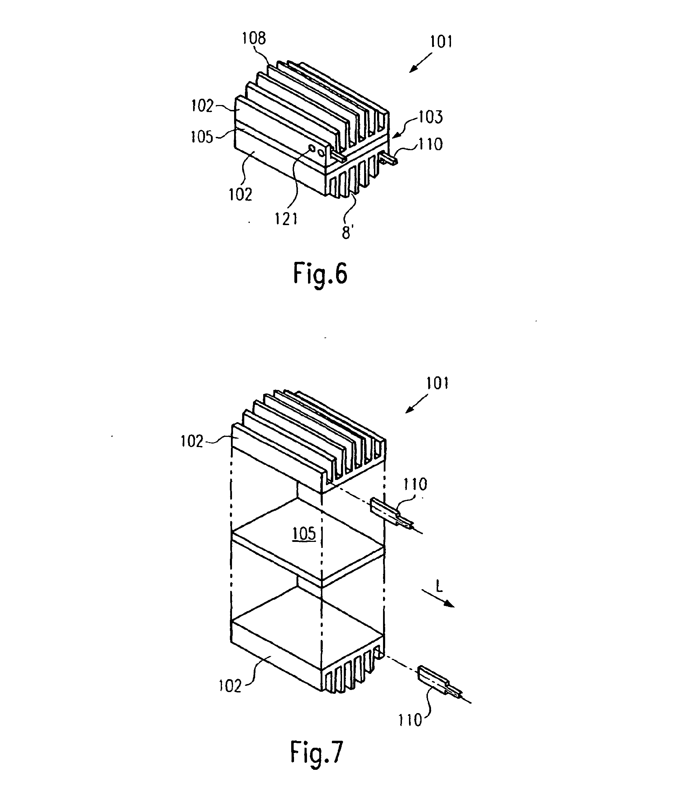

Die Fig. 6 und 7 zeigen eine zweite beispielhafte Ausführungsform des elektrischen Platinenheizbausteins 101. Im Folgenden wird nur auf die Unterschiede zu der Ausführungsform der Fig. 1 und 2 eingegangen.

Im Gegensatz zu der Ausführungsform der Fig. 1 und 2 weist die Ausführungsform der Fig. 6 und 7 zwei getrennte Heizkörper 102 auf. Zwischen den beiden im Wesentlichen gleich ausgestalteten Heizkörpern 102 ist das Heizelement 103 angeordnet. An jedem Heizkörper 102 sind, ähnlich wie bei der Ausführungsform der Fig. 1 und 2, Heizvorsprünge 108 vom Heizkörper 102 im Wesentlichen quer zur Längsrichtung L wegstehend angeordnet.

Das Heizelement 103 der in Fig. 6 und 7 dargestellten Ausführungsform besteht insbesondere aus einem PTC-Element 105, das zwischen den Heizkörpern 102 angeordnet ist.
Die Energieeinleitung in das PTC-Element 105 erfolgt bei der in Fig. 6 und 7 dargestellten Ausführungsform insbesondere über die beiden Heizkörper 102, die als Elektrodenkörper des Heizelementes103 ausgestaltet sind. Der Stapel aus dem PTC-Element 105 und den beiden Heizkörpern 102 ist bei der in Fig. 6 und 7 dargestellten Ausführungsform mit einem geeigneten Klebstoff zusammengeklebt. Um einen guten Wärmefluss vom PTC-Element 105 zu den beiden Heizkörpern 102 zu gewährleisten, ist der verwendete Klebstoff gut wärmeleitfähig. Weiterhin sind die Kontaktflächen der Heizkörper 102 und des PTC-Elements 105 zueinander im Wesentlichen flächengleich und plan ausgebildet, wodurch die Kontaktflächen im Wesentlichen ohne Lücken und Luftspalte gut wärmeübertragend aufeinanderliegen. Alternativ zur Klebeverbindung können die Heizkörper 102 und das PTC-Element 105 auch durch ein Klammerelement zusammengedrückt oder verlötet sein.

Die Befestigungselemente 110 sind mit Befestigungsmitteln, bei der in Fig. 6 und 7 dargestellten Ausführungsform insbesondere mit Nieten 121, an einem der Heizvorsprünge 108 der beiden Heizkörper 102 angebracht. Alternativ können die Befestigungselemente 110 auch mit den Heizkörpern 102 durch Umformen verquetscht oder einteilig ausgestaltet sein. Wie bei der Ausführungsform der Fig. 1 und 2, ist auch bei der in Fig. 6 und 7 dargestellten Ausführungsform der Platinenheizbaustein 101 durch die Befestigungselemente 110 mit einer Energiequelle verbindbar.

Die in den Fig. 6 und 7 dargestellten Ausführungsformen des erfindungsgemäßen Platinenheizbausteins 101 umfasst im Vergleich zu der in Fig. 1 und 2 dargestellten Ausführungsform weniger Einzelteile und ist mit geringeren Herstellungskosten herstellbar. Da die Heizkörper 102 der in Fig. 6 und 7 dargestellten Ausführungsform im Betrieb des Platinenheizbausteins 101 unter elektrischer Spannung stehen, eignet sich diese Ausführungsform insbesondere für den Einsatz auf von Personen unzugänglichen Elektronikplatinen.

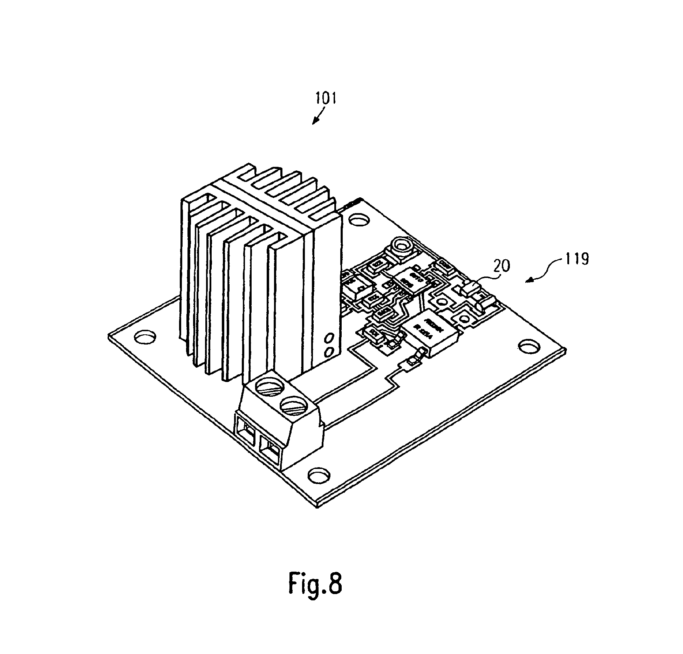

Fig. 8 zeigt eine weitere beispielhafte Ausführungsform der erfindungsgemäßen Elektronikplatine 119, auf welche der Platinenheizbaustein 101 der Fig. 6 und 7 angeordnet ist. Ansonsten ist die in Fig. 8 dargestellte Ausführungsform mit der in Fig. 3 gleich.

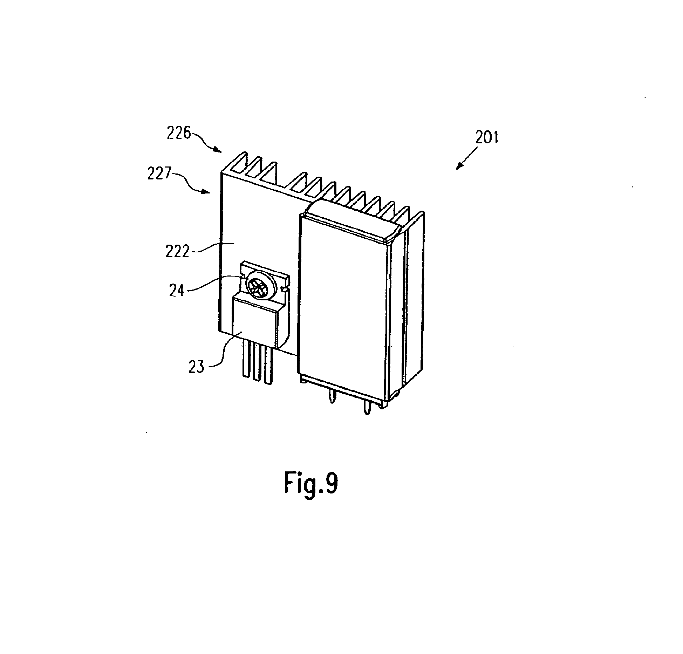

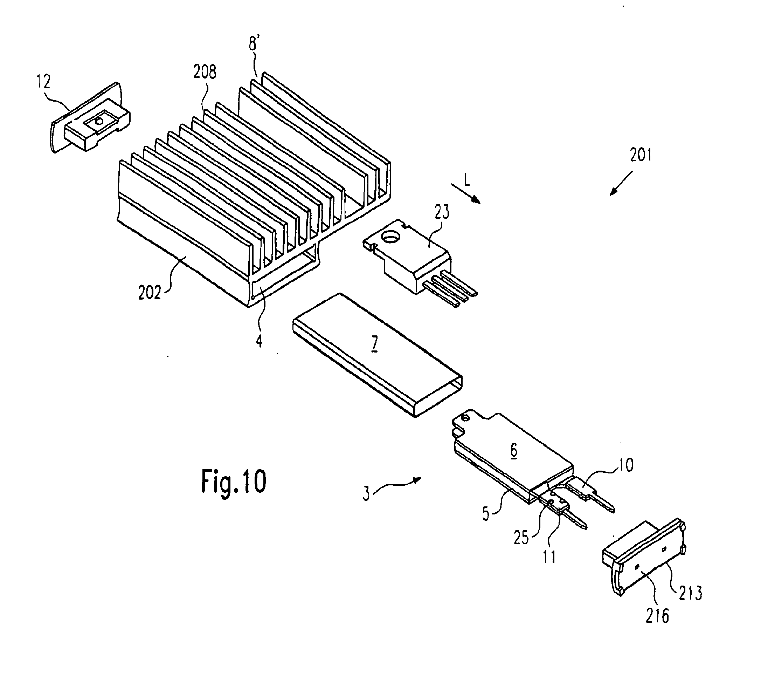

Fig. 9 und 10 zeigen eine dritte beispielhafte Ausführungsform des erfindungsgemäßen Platinenheizbausteins 201. Im Folgenden wird nur auf die Unterschiede zu der in den Fig. 1 und 2 dargestellten Ausführungsform eingegangen.

Der Heizkörper 202 weist bei der in Fig. 9 und 10 dargestellten Ausführungsform nur an einer Seite der Aufnahme 4 Heizvorsprünge 208 auf. Die Heizvorsprünge 208 sind zueinander im Wesentlichen gleich ausgestaltet, sind in einem Heizvorsprungbereich 226 des Heizkörpers 2 angeordnet und verlaufen parallel zueinander in der Längsrichtung L. In einem zur Aufnahme 4 und den Heizvorsprüngen 208 gegenüberliegenden Heizflächenbereich 227 ist eine Kontaktheizfläche 222 am Heizkörper 2 ausgebildet. An der Kontaktheizfläche 222 ist ein durch Kontakt zu beheizendes elektrisches Bauelement 23 angebracht.

Durch die Kontaktheizfläche 222 wird das Bauelement 23 im Betrieb durch den Kontakt zum Platinenheizbaustein 201 beheizt. Hierdurch wird ein Teil der vom Heizelement 3 erzeugten Wärmeenergie an das durch Kontakt zu beheizende Bauelement 23 geleitet. Die restliche Wärmeenergie wird durch Konvektion und/oder Strahlung über die Heizvorsprünge 208, wie bei den Ausführungsformen der Fig. 1, 2, 6 und 7, abgegeben. Das durch Kontakt zu beheizende Bauelement 23 ist im montierten Zustand mit einem Befestigungsmittel, z.B. einer Schraube 24, an der Kontaktheizfläche 222 des Heizkörpers 202 befestigt. In der Kontaktheizfläche 222 ist hierfür ein entsprechendes Innengewinde (nicht dargestellt) ausgebildet. Alternativ können auch andere geeignete Befestigungsmittel, z.B. Nieten, verwendet werden oder das Bauelement 23 kann durch Kleben mit der Kontaktheizfläche 222 verbunden sein.

Das durch Kontakt zu beheizende Bauelement 23 kann beispielsweise ein Oszillator sein, der im Betrieb auf einer konstanten Temperatur gehalten wird. Alternativ kann ein Oszillator selbstverständlich auch als ein beabstandetes Bauelement 20 angeordnet und vom erfindungsgemäßen Platinenheizbaustein 1, 101, 201 beheizt werden.

Wie bei der in Fig. 1 und 2 dargestellten Ausführungsform ist das Heizelement 3 in der Aufnahme 4 des Heizkörpers 202 angeordnet. Bei der in Fig. 10 dargestellten Ausführungsform sind an den Befestigungselementen 10 Klammerelemente 25 ausgebildet, welche die Kontaktplatten 11 der Elektrodenkörper 6 umklammern und dadurch an den Kontaktplatten 11 befestigt sind.
Das untere Verschlusselement 213 ist wie das oben beschriebene Verschlusselement 13 aus den Fig. 1 und 2 ausgebildet, wobei der Boden 216 nicht kreisförmig sondern im Wesentlichen rechteckig ausgebildet ist.

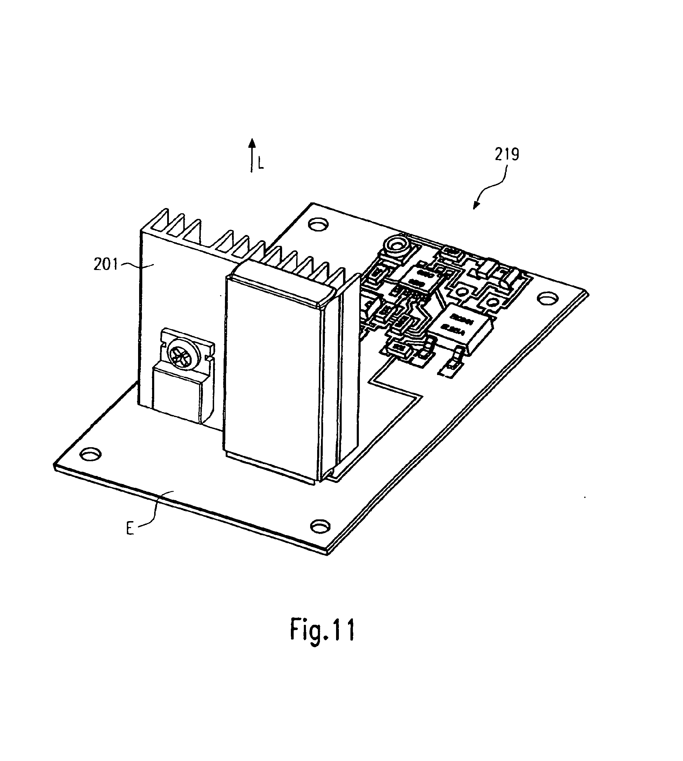

Fig. 11 zeigt eine dritte beispielhafte Ausführungsform der erfindungsgemäßen Elektronikplatine 219, auf welcher der Platinenheizbaustein 201 der Fig. 9 und 10 angeordnet ist. Ansonsten ist die in Fig. 11 dargestellte Ausführungsform mit der in Fig. 3 gleich.

## Patentansprüche

1. Elektrischer Platinenheizbaustein (1, 101, 201) zum Beheizen von auf einer Elektronikplatine (19, 119, 219) angeordneten elektrischen Bauelementen (20) sowie benachbarten Baueinheiten, mit wenigstens einem Befestigungselement (10, 110), mit dem der Platinenheizbaustein (1, 101, 201) auf oder an der Elektronikplatine (19, 119) anbringbar ausgestaltet ist, mit wenigstens einem PTC-Heizelement (3, 103) zur Erzeugung von Wärmeenergie und mit wenigstens einem Heizkörper (2, 102, 202), der die im Betrieb des Platinenheizbausteins (1, 101, 201) vom Heizelement (3, 103) erzeugte und die Bauelemente (20) beheizende Wärmeenergie über eine Wärmeabgabefläche (9) abgibt und an dem ein oder mehrere als Konvektions- und Abstrahlelemente ausgebildete Heizvorsprünge (8, 108, 208) angeordnet sind, durch welche die Wärmeabgabefläche (9) vergrößert und die Wärmeenergie im Wesentlichen gerichtet abgebbar ist, **dadurch gekennzeichnet, dass** der Platinenheizbaustein (1, 201) wenigstens einen elektrisch isolierenden Boden (16) aufweist, mit dem der Platinenheizbaustein (1, 201) auf der Elektronikplatine (19, 119, 219) anordenbar ausgebildet ist.

2. Elektrischer Platinenheizbaustein (1, 101, 201) nach Anspruch 1, **dadurch gekennzeichnet, dass** der Heizkörper (2, 102, 202) als ein Strangpressprofil ausgebildet ist.

3. Elektrischer Platinenheizbaustein (1, 101, 201) nach Anspruch 1 oder 2, **dadurch gekennzeichnet, dass** zwischen den Heizvorsprüngen (8, 108, 208) Zirkulationskanäle (8') ausgebildet sind, die von einem Umgebungsgas durchströmbar sind.

4. Elektrischer Platinenheizbaustein (1, 101, 201) nach einem der oben genannten Ansprüche, **dadurch gekennzeichnet, dass** der Heizkörper (2, 102, 202) eine Aufnahme (4) aufweist, in der das Heizelement (3, 103) angeordnet ist.

5. Elektrischer Platinenheizbaustein (1, 101, 201) nach Anspruch 4, **dadurch gekennzeichnet, dass** das Heizelement (3, 103) in der Aufnahme (4) verpresst ist.

6. Elektrischer Platinenheizbaustein (1, 101, 201) nach Anspruch 4, **dadurch gekennzeichnet, dass** das Heizelement (3, 103) in der Aufnahme (4) vergossen ist.

7. Elektrischer Platinenheizbaustein (1, 101, 201) nach einem der Ansprüche 4 bis 6, **dadurch gekennzeichnet, dass** in den Enden der Aufnahme (4) elektrisch isolierende Verschlusselemente (12, 13, 213) angeordnet sind.

8. Elektrischer Platinenheizbaustein (1, 101, 201) nach einem der oben genannten Ansprüche, **dadurch gekennzeichnet, dass** der wenigstens eine Heizkörper (2, 102, 202) mit wenigstens einem Elektrodenkörper (6) des Heizelementes (3, 103) einteilig ausgestaltet ist.

9. Elektrischer Platinenheizbaustein (1, 101, 201) nach einem der oben genannten Ansprüche, **dadurch gekennzeichnet, dass** das wenigstens eine Befestigungselement (10, 110) als elektrisches Kontaktelement ausgebildet ist, das zur Energieversorgung der Platinenheizbaustein (1, 101, 201) mit einer Energiequelle elektrisch verbindbar ausgestaltet ist.

10. Elektrischer Platinenheizbaustein (1, 101, 201) nach einem der oben genannten Ansprüche, **dadurch gekennzeichnet, dass** das wenigstens eine Befestigungselement (10, 110) mit einem der Elektrodenkörper (6) des Heizelementes (3, 103) einteilig ausgebildet ist.

11. Elektrischer Platinenheizbaustein (1, 101, 201) nach einem der oben genannten Ansprüche, **dadurch gekennzeichnet, dass** das Befestigungselement als Steckverbinder ausgebildet ist, der in die Elektronikplatine (19, 119) einsteckbar ist.

12. Elektrischer Platinenheizbaustein (1, 101, 201) nach einem der oben genannten Ansprüche, **dadurch gekennzeichnet, dass** ein durch Kontakt zu beheizendes elektrisches Bauelement (23) an einer Kontaktheizfläche (222) des Platinenheizbausteins (1, 101, 201) wärmeleitend angeordnet ist.

13. Elektrischer Platinenheizbaustein (1, 101, 201) nach einem der oben genannten Ansprüche, **dadurch gekennzeichnet, dass** die Grenztemperatur (T_{ref}), bei der sich der elektrische Widerstand eines PTC-Elementes (5, 105) des Heizelementes (3, 103) ändert, abhängig vom Material des PTC-Elementes (5, 105) ist.

14. Elektronikplatine (19, 119) mit wenigstens einem elektrischen Platinenheizbaustein (1, 101, 201) und anderen elektrischen Bauelementen (20), wobei der Platinenheizbaustein (1, 101, 201) zum Beheizen der übrigen Bauelemente (20) ausgebildet und mit wenigstens einem Befestigungselement (10, 110) neben den übrigen Bauelementen (20) auf oder an der Elektronikplatine (19, 119) angebracht ist, **dadurch gekennzeichnet, dass** der nach einem der oben genannten Ansprüche ausgestaltete Platinenheizbaustein (1, 101, 201) so auf der Elektronikplatine (19, 119) angeordnet ist, dass sich im Betrieb die vom Platinenheizbaustein (1, 101, 201) erzeugte Wärmenergie direkt durch Wärmestrahlung oder indirekt durch Konvektion über ein Umgebungsgas zu den vom Platinenheizbaustein (1, 101, 201) beabstandeten Bauelementen (20) überträgt.

15. Elektronikplatine (19, 119) nach Anspruch 14, **dadurch gekennzeichnet, dass** der Platinenheizbaustein (1, 101, 201) als eine vormontierbare separate Baueinheit ausgebildet ist.

16. Verfahren zum Beheizen von auf einer Elektronikplatine (19, 119) angeordneten elektrischen Bauelementen (20) mit einer auf der Elektronikplatine (19, 119) angeordneten und ein Heizelement (3, 103) und einen Heizkörper (2, 102, 202) umfassenden, nach einem der oben genannten Ansprüchen ausgestalteten Platinenheizbaustein (1, 101, 201), wobei bei dem Verfahren Wärmeenergie durch das Heizelement (3, 103) erzeugt, an den Heizkörper (2, 102, 202) übertragen und von Heizvorsprüngen (8, 108, 208) des Heizkörpers (2, 102, 202) indirekt durch Konvektion über ein Umgebungsgas und/oder direkt durch Wärmestrahlung an die zu beheizenden Bauelemente (20) übertragen wird.

## Claims

1. An electric PCB heating component (1, 101, 201) for heating electric components (20) arranged on an electronic circuit board (19, 119, 219) and adjacent units, comprising at least one fastening element (10, 110) by which the PCB heating component (1, 101, 201) is attachable to the electronic circuit board (19, 119), at least one PTC heating element (3, 103) for generating thermal energy, and at least one heating body (2, 102, 202) which emits via a heat radiating surface (9) the thermal energy generated by the heating element (3, 103) when the PCB heating component (1, 101, 201) is in operation, said thermal energy heating the components (20), and which has arranged thereon one or a plurality of heating projections (8, 108, 208) implemented as convection and radiation elements, which enlarge the heat radiating surface (9) and by means of which the thermal energy can be emitted in a substantially directional mode, **characterized in that** the PCB heating component (1, 201) comprises at least one electrically insulating base (16) with which the PCB heating component (1, 201) can be arranged on the electronic circuit board (19, 119, 219).

2. An electric PCB heating component (1, 101, 201) according to claim 1, **characterized in that** the heating body (2, 102, 202) is implemented as an extrusion profile.

3. An electric PCB heating component (1, 101, 201) according to claim 1 or 2, **characterized in that** circulation passages (8') through which an ambient gas can flow are formed between the heating projections (8, 108, 208).

4. An electric PCB heating component (1, 101, 201) according to one of the above-mentioned claims, **characterized in that** the heating body (2, 102, 202) includes a reception means (4) in which the heating element (3, 103) is arranged.

5. An electric PCB heating component (1, 101, 201) according to claim 4, **characterized in that** the heating element (3, 103) is press-fitted into the reception means (4).

6. An electric PCB heating component (1, 101, 201) according to claim 4, **characterized in that** the heating element (3, 103) is potted in the reception means (4).

7. An electric PCB heating component (1, 101, 201) according to one of the claims 4 to 6, **characterized in that** electrically insulating closure members (12, 13, 213) are arranged in the ends of the reception means (4).

8. An electric PCB heating component (1, 101, 201) according to one of the above-mentioned claims, **characterized in that** the at least one heating body (2, 102, 202) is formed integrally with at least one electrode body (6) of the heating element (3, 103).

9. An electric PCB heating component (1, 101, 201) according to one of the above-mentioned claims, **characterized in that** the at least one fastening element (10, 110) is embodied as an electric contact element which is implemented such that it can be electrically connected to an energy source so as to supply energy to the PCB heating component (1, 101, 201).

10. An electric PCB heating component (1, 101, 201) according to one of the above-mentioned claims, **characterized in that** the at least one fastening element (10, 100) is formed integrally with one of the electrode bodies (6) of the heating element (3, 103).

11. An electric PCB heating component (1, 101, 201) according to one of the above-mentioned claims, **characterized in that** the fastening element is embodied as a plug connector which is adapted to be plugged into the electronic circuit board (19, 119),

12. An electric PCB heating component (1, 101, 201) according to one of the above-mentioned claims, **characterized in that** an electric component (23) which is to be heated by contact is arranged in a thermally conductive manner on a contact heating surface (222) of the PCB heating component (1, 101, 201).

13. An electric PCB heating component (1, 101, 201) according to one of the above-mentioned claims, **characterized in that** the limit temperature (T_{ref}) at which the electric resistance of a PTC element (5, 105) of the heating element (3, 103) changes depends on the material of the PTC element (5, 105).

14. An electronic circuit board (19, 119) comprising at least one PCB heating component (1, 101, 201) and other electric components (20), said PCB heating component (1, 101, 201) being configured to heat the other components (20) and being attached by means of at least one fastening element (10, 110) to the electronic circuit board (19, 119) adjacent the other components (20), **characterized in that** the PCB heating component (1, 101, 201) implemented according to one of the above-mentioned claims is arranged on the electronic circuit board (19, 119) in such a way that, when it is in operation, the thermal energy generated by the PCB heating component (1, 101, 201) is transferred either directly through heat radiation or indirectly through convection via an ambient gas to the components (20) spaced apart from the PCB heating component (1, 101, 201).

15. An electronic circuit board (19, 119) according to claim 14, **characterized in that** the PCB heating component (1, 101, 201) is implemented as a premountable separate structural unit.

16. A method of heating electric components (20) arranged on an electronic circuit board (19, 119) by means of a PCB heating component (1, 101, 201), which is arranged on said electronic circuit board (19, 119) and includes a heating element (3, 103) and a heating body (2, 102, 202) and which is implemented according to one of the above-mentioned claims, said method comprising the steps of generating thermal energy by means of the heating element (3, 103), transferring said thermal energy to the heating body (2, 102, 202) and transferring it, indirectly through convection via an ambient gas and/or directly through heat radiation, from the heating projections (8, 108, 208) of the heating body (2, 102, 202) to the components (20) to be heated.

## Revendications

1. Elément chauffant électrique de carte de circuit imprimé (1, 101, 201) pour le chauffage de composants électriques (20) disposés sur une carte de circuit imprimé (19, 119, 219) ainsi que de composants voisins, avec au moins un élément de fixation (10, 110) avec lequel l'élément chauffant d'une carte de circuit imprimé (1, 101, 201) peut être monté sur la carte de circuit imprimé (19, 119) ou fixé à celle-ci, avec au moins un élément de chauffage à coefficient positif de température (PTC) (3, 103) pour la génération de l'énergie calorifique et avec au moins un corps de chauffe (2, 102, 202) qui restitue par l'intermédiaire d'une surface de restitution de chaleur (9) l'énergie calorifique qui est générée par l'élément de chauffage (3, 103) lors du fonctionnement de l'élément chauffant de carte de circuit imprimé (1, 101, 201) et qui chauffe les composants (20) et sur lequel sont disposées une ou plusieurs saillies de chauffage (8, 108, 208) qui sont disposées comme éléments de convection et de rayonnement au moyen desquelles la surface de restitution de chaleur (9) est agrandie et l'énergie calorifique peut être restituée en étant sensiblement guidée, **caractérisé en ce que** l'élément chauffant de carte de circuit imprimé (1, 201) présente au moins un fond assurant une isolation électrique (16) avec lequel l'élément chauffant de carte de circuit imprimé (1, 201) est formé de manière à pouvoir être disposé sur la carte de circuit imprimé (19, 119, 219).

2. Elément chauffant électrique de carte de circuit imprimé (1, 101, 201) selon la revendication 1, **caractérisé en ce que** le corps de chauffe (2, 102, 202) est formé comme un profilé extrudé.

3. Elément chauffant électrique de carte de circuit imprimé (1, 101, 201) selon la revendication 1 ou 2, **caractérisé en ce qu'**entre les saillies de chauffage (8, 108, 208) sont formés des canaux de circulation (8') qui peuvent être traversés par un gaz ambiant.

4. Elément chauffant électrique de carte de circuit imprimé (1, 101, 201) selon l'une des revendications mentionnées précédemment, **caractérisé en ce que** le corps de chauffe (2, 102, 202) présente un réceptacle (4) dans lequel est disposé l'élément de chauffage (3, 103).

5. Elément chauffant électrique de carte de circuit imprimé (1, 101, 201) selon la revendication 4, **caractérisé en ce que** l'élément de chauffage (3, 103) est fixé par pressage dans le réceptacle (4).

6. Elément chauffant électrique de carte de circuit imprimé (1, 101, 201) selon la revendication 4, **caractérisé en ce que** l'élément de chauffage (3, 103) est scellé dans le réceptacle (4).

7. Elément chauffant électrique de carte de circuit imprimé (1, 101, 201) selon l'une des revendications 4 à 6, **caractérisé en ce que** dans les extrémités du réceptacle (4) sont placés des éléments d'obturation (12, 13, 213) qui assurent une isolation électrique.

8. Elément chauffant électrique de carte de circuit imprimé (1, 101, 201) selon l'une des revendications mentionnées précédemment, **caractérisé en ce que** l'au moins un corps de chauffe (2, 102, 202) est configuré d'une seule pièce avec au moins un corps d'électrode (6) de l'élément de chauffage (3, 103).

9. Elément chauffant électrique de carte de circuit imprimé (1, 101, 201) selon l'une des revendications mentionnées précédemment, **caractérisé en ce que** l'au moins un élément de fixation (10, 110) est formé comme élément de contact électrique qui est configuré pour faire l'objet d'une liaison électrique avec une source d'énergie pour l'alimentation en énergie de l'élément chauffant de carte de circuit imprimé (1, 101, 201).

10. Elément chauffant électrique de carte de circuit imprimé (1, 101, 201) selon l'une des revendications mentionnées précédemment, **caractérisé en ce que** l'au moins un élément de fixation (10, 110) est formé d'une seule pièce avec l'un des corps d'électrode (6) de l'élément de chauffage (3, 103).

11. Elément chauffant électrique de carte de circuit imprimé (1, 101, 201) selon l'une des revendications mentionnées précédemment, **caractérisé en ce que** l'élément de fixation est formé comme connecteur enfichable qui peut être inséré dans la carte de circuit imprimé (19, 119).

12. Elément chauffant électrique de carte de circuit imprimé (1, 101, 201) selon l'une des revendications mentionnées précédemment, **caractérisé en ce qu'**un composant électrique (23) qui doit être chauffé par contact est disposé en conduction thermique sur une surface de chauffage par contact (222) de l'élément chauffant de carte de circuit imprimé (1, 101, 201).

13. Elément chauffant électrique de carte de circuit imprimé (1, 101, 201) selon l'une des revendications précédentes, **caractérisé en ce que** la température limite (T_{ref}) pour laquelle la résistance électrique d'un élément de chauffage à coefficient positif de température (PTC) (5, 105) de l'élément de chauffage (3, 103) change est dépendante du matériau de l'élément de chauffage à coefficient positif de température (PTC) (5, 105).

14. Carte de circuit imprimé (19, 119) avec au moins un élément chauffant électrique de carte de circuit imprimé (1, 101, 201) et d'autres composants électriques (20), dans laquelle l'élément chauffant de carte de circuit imprimé (1, 101, 201) est formé pour chauffer les autres composants (20) et est, au moyen d'au moins un élément de fixation (10, 110), monté sur la carte de circuit imprimé (19, 119) ou fixé à celle-ci à côté des autres composants (20), **caractérisée en ce que** l'élément chauffant de carte de circuit imprimé (1, 101, 201) qui est configuré selon l'une des revendications mentionnées précédemment est disposé de telle façon sur la carte de circuit imprimé (19, 119) que lors du fonctionnement l'énergie calorifique générée par l'élément chauffant de carte de circuit imprimé (1, 101, 201) soit transmise directement par rayonnement thermique ou indirectement par convection par l'intermédiaire d'un gaz ambiant aux composants (20) qui sont espacés de l'élément chauffant de carte de circuit imprimé (1, 101, 201).

15. Carte de circuit imprimé (19, 119) selon la revendication 14, **caractérisée en ce que** l'élément chauffant de carte de circuit imprimé (1, 101, 201) est formé comme un module séparé pouvant faire l'objet d'un montage préalable.

16. Procédé de chauffage de composants électriques (20) disposés sur une carte de circuit imprimé (19, 119), avec un élément chauffant d'une carte de circuit imprimé (1, 101, 201) qui est agencé selon l'une des revendications mentionnées précédemment, qui est disposé sur la carte de circuit imprimé (19, 119) et qui comprend un élément de chauffage (3, 103) ainsi qu'un corps de chauffe (2, 102, 202), dans lequel par ce procédé de l'énergie calorifique est générée au moyen de l'élément de chauffage (3, 103), est transmise au corps de chauffe (2, 102, 202) et est transmise par des saillies de chauffage (8, 108, 208) du corps de chauffe (2, 102, 202) indirectement par convection par l'intermédiaire d'un gaz ambiant et/ou directement par rayonnement thermique aux composants à chauffer (20).
